Europäisches Patentamt

European Patent Office

Office européen des brevets

(19)

(11) Veröffentlichungsnummer: **0 013 364**
**A1**

(12) ## EUROPÄISCHE PATENTANMELDUNG

(21) Anmeldenummer: **79105076.8**

(22) Anmeldetag: **10.12.79**

(51) Int. Cl.³: **H 01 F 15/04**
**H 03 H 1/00, H 05 K 9/00**
**H 01 F 27/36**

(30) Priorität: **27.12.78 DE 7838484 U**

(43) Veröffentlichungstag der Anmeldung:
**23.07.80 Patentblatt 80/15**

(84) Benannte Vertragsstaaten:
**BE FR SE**

(71) Anmelder: **SIEMENS AKTIENGESELLSCHAFT**
**Postfach 22 02 61**
**D-8000 München 22(DE)**

(72) Erfinder: **Ristig, Eberhard, Dipl.-Ing.**
**Almstr. 1a**
**D-8411 Etterzhausen(DE)**

(54) **Funk-Entstördrossel.**

(57) Stromkompensierte, in einen Kunststoffbecher (1) eingegossene Ringkern-Zweifachdrossel (7) mit auf den Kunststoffbecher aufgeschobenem Aluminiumbecher (5) und zwischen Kunststoff- und Aluminiumbecher angeordneten
Dynamoblechen (3,4).

FIG 1

EP 0 013 364 A1

0013364

SIEMENS AKTIENGESELLSCHAFT    Unser Zeichen
Berlin und München           VPA 78 P 1 2 2 8 EUR

## Funk-Entstördrossel

Die Erfindung betrifft eine Funk-Entstördrossel, insbesondere stromkompensierte Ringkern-Zweifachdrossel, die in
einen Kunststoffbecher eingegossen ist und wie dies im
Siemens-Datenbuch 1977/78, Seite 163, dargestellt ist,
bevorzugt Anschlußstifte im Rastermaß aufweist.

Bei Störspannungsmessungen an Schaltnetzteilen stellt
sich häufig heraus, daß eine Entstörbeschaltung mit Einzelbauteilen, nämlich mit Funk-Entstördrosseln, ausreichend ist, wenn die Bauelemente außerhalb des Schaltnetzteilgehäuses angeschaltet sind. Wird die Entstörbeschaltung in das Gehäuse integriert, ergibt sich eine erhebliche Verschlechterung der Entstörwirkung, d.h. es wird
ein höherer Störpegel gemessen. Der Wandler und der
Schalttransistor erzeugen starke magnetische Felder, die
auf die Funk-Entstördrossel einkoppeln und ihre Dämpfungseigenschaften verschlechtern. Die Bildung einer geschirmten Kammer für die gesamte Entstörbeschaltung, die diesem
Nachteil entgegenwirkt, ist im Schaltnetzteilgehäuse auf-

Kra 1 Mi  20.12.1978

0013364

78 P 1 2 2 8 EUR

grund des gedrängten Aufbaus vielfach nicht möglich.

Denkbar ist zwar eine Schirmung allein der Funk-Entstördrossel mittels Umhüllung mit einem Aluminiumbecher; durch diesen Aluminiumbecher werden jedoch die aus dem Kern der Funk-Entstördrossel austretenden Feldlinien beeinflußt, was zu einer Herabsetzung der Streuinduktivität und damit zu einer verschlechterten Entstörung der symmetrischen Störkomponente führt.

Es ist Aufgabe der vorliegenden Erfindung eine in das Gehäuse des Schaltnetzteiles integrierbare, durch einen Aluminiumbecher geschirmte Funk-Entstördrossel der eingangs genannten Art zu schaffen, welche die zur Entstörung der symmetrischen Störkomponente notwendige Streuinduktivität besitzt.

Bei einer Funk-Entstördrossel, insbesondere stromkompensierten, in einen Kunststoffbecher eingegossenen Ringkern-Zweifachdrossel, sieht die Erfindung zur Lösung vorstehend genannter Aufgabe vor, daß auf den Kunststoffbecher ein Aluminiumbecher aufgeschoben ist und zwischen Kunststoff- und Aluminiumbecher Dynamobleche angeordnet sind.

Bevorzugt sind dabei sämtliche zueinander benachbarten Flächen des Kunststoff- und Aluminiumbechers durch Dynamobleche voneinander getrennt.

Zum Einsatz in Leiterplatten ist die Ringkern-Zweifachdrossel zweckmäßigerweise mit im Rastermaß angeordneten Anschlußstiften ausgebildet, die im Bereich der Aluminiumbecher-Öffnung aus dem Kunststoffbecher herausgeführt sind.

0013364

78 P 1 2 2 8 EUR

Untersuchungen haben gezeigt, daß durch die als Aluminiumbecher ausgebildete Schirmung die Streuinduktivität stark, im untersuchten Fall z.B. um die Hälfte erniedrigt wird und diese Erniedrigung durch den Einsatz der Dynamobleche völlig rückgängig gemacht werden kann. Auch die Scheinwiderstandskurven der ungeschirmten wie auch der geschirmten und mit Dynamoblechen umhüllten Funk-Entstördrossel zeigen keinerlei Unterschiede. Die Abhängigkeit der Nenninduktivität vom Laststrom erhöht sich bei der geschirmten Funk-Entstördrossel gemäß der Erfindung Der doppelte Nennstrom führt zu einem Abfall von 5 % bei der ungeschirmten Funk-Entstördrossel und zu einem Abfall von 10 % bei der geschirmten.

Die Erfindung wird nachstehend anhand eines Ausführungs- und eines Anwendungsbeispieles näher erläutert. Es zeigt:

Fig. 1 ein Ausführungsbeispiel des Gegenstandes nach der Erfindung in perspektivischer und auseinandergezogener Darstellung,

Fig. 2 eine Unteransicht des Ausführungsbeispieles nach Fig. 1, wobei die Ringkern-Zweifachdrossel schematisch angedeutet ist,

Fig. 3 das Schaltschema für eine Entstörbeschaltung mit stromkompensierter Ringkern-Zweifachdrossel nach der Erfindung für ein Schaltnetzteil für eine Xenon-Lampe mit 500 W Leistung,

Fig. 4 Vergleichskurven, aus denen die Dämpfung des Störsignals, gemessen in dB als Funktion der Frequenz, erkennbar ist, wobei die Entstörbeschaltung nach Fig. 3

a) eine ungeschirmte Ringkerndrossel aufweist und im Gehäuse des Schaltnetzteiles untergebracht ist (siehe Kurve 1);

b) eine geschirmte Ringkerndrossel nach der Erfindung aufweist und im Gehäuse des Schaltnetzteiles untergebracht ist (siehe Kurve 2);

c) eine ungeschirmte Ringkerndrossel aufweist und außerhalb des Schaltnetzteil-Gehäuses angeordnet ist (siehe Kurve 3).

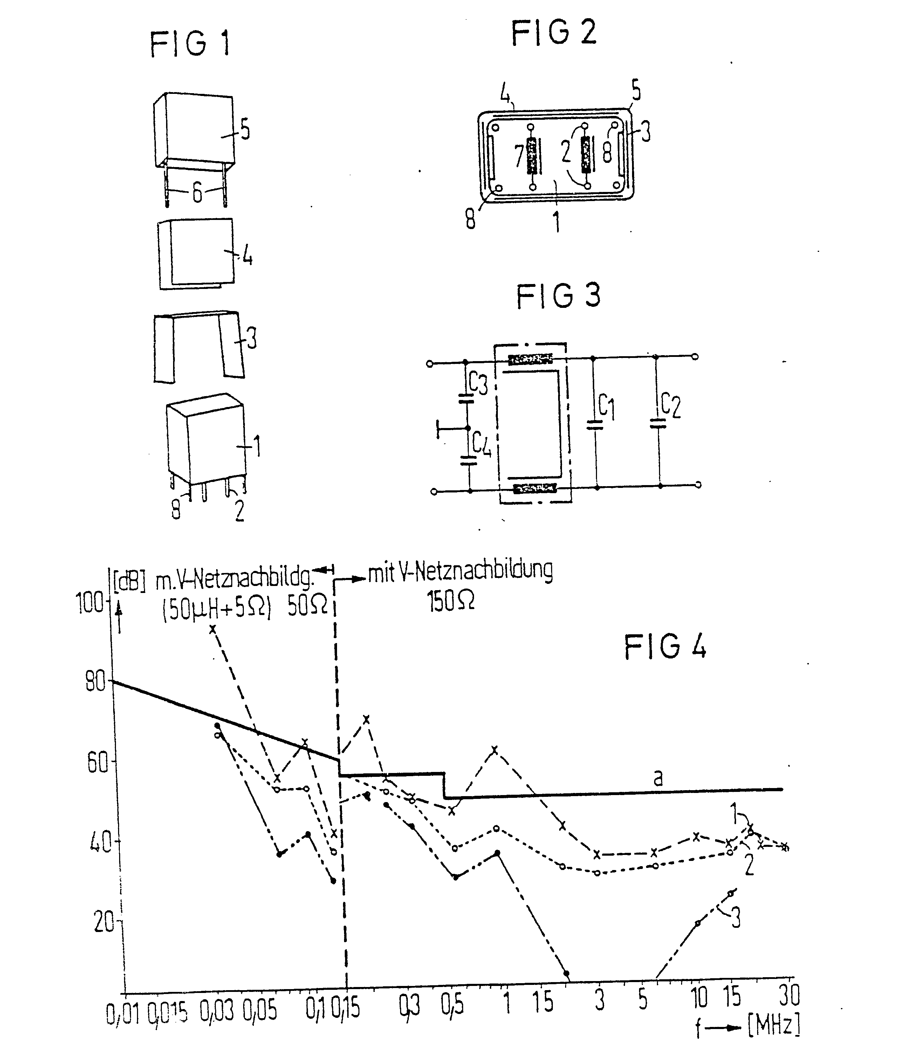

In der Explosions-Darstellung nach Fig. 1 ist mit 1 ein vergossener Kunststoffbecher bezeichnet, der eine stromkompensierte und mit Anschlußstiften 2 im Rastermaß versehene stromkompensierte Ringkern-Zweifachdrossel 7 enthält. Auf diesen quaderförmigen Kunststoffbecher sind in der gezeigten Reihenfolge U-förmige Dynamobleche 3, 4 und ein als Schirmung dienender Aluminiumbecher 5 aufgeschoben. Der Aluminiumbecher 5 liegt über Anschlüsse 6 an Anschlußstiften 8, die als Massekontakte dienen.

Die zur Entstörung des Schaltnetzteiles für eine Xenon-Lampe dienende Entstörbeschaltung nach Fig. 3 enthält eine stromkompensierte Ringkern-Zweifachdrossel hoher Induktivität, zwei Kondensatoren $C_1$, $C_2$ und zwei gegen Masse geschaltete Kondensatoren $C_3$ und $C_4$.

Ordnet man diese Entstörbeschaltung außerhalb des Schaltnetzteil-Gehäuses an, so ergibt sich, wie die Kurve 3 zeigt, eine ausreichende Entstörung. Ordnet man die gleiche Entstörbeschaltung mit ungeschirmter Ringkern-Zweifachdrossel im Schaltnetzteil-Gehäuseinneren an, so ist die Entstörwirkung der Entstörbeschaltung unzureichend; die Grenzkurve a) wird mehrfach überschritten. Schirmt man hingegen die Ringkern-Zweifachdrossel ab und ordnet zudem Dynamobleche zwischen der Schirmung und der Drossel an, so werden wiederum Werte erreicht, die
unterhalb der Grenzkurve a) liegen.


4 Patentansprüche
4 Figuren

- 1 -    78 P 1 2 2 8 EUR

## Patentansprüche

1. Funk-Entstördrossel, insbesondere stromkompensierte, in einen Kunststoffbecher eingegossene Ringkern-Zweifachdrossel, d a d u r c h g e k e n n z e i c h n e t , daß auf den Kunststoffbecher (1) ein Aluminiumbecher (5) aufgeschoben ist und zwischen Kunststoff- und Aluminiumbecher Dynamobleche (3, 4) angeordnet sind.

2. Funk-Entstördrossel nach Anspruch 1, dadurch gekennzeichnet, daß sämtliche zueinander benachbarten Flächen des Kunststoff- und Aluminiumbechers (1 bzw. 5) durch Dynamobleche (3, 4) voneinander getrennt sind.

3. Funk-Entstördrossel nach Anspruch 1 und 2, dadurch gekennzeichnet, daß die Ringkern-Zweifachdrossel (7) Anschlußstifte (2) im Rastermaß aufweist, die im Bereich der Aluminiumbecher-Öffnung aus dem Kunststoffbecher (1) herausgeführt sind.

4. Funk-Entstördrossel nach den vorhergehenden Ansprüchen, dadurch gekennzeichnet, daß der Aluminiumbecher (5) über Anschlüsse (6) an Anschlußstiften (8) liegt, die als Massekontakte dienen.

0013364

1/1

FIG 1

FIG 2

FIG 3

FIG 4

| Kategorie | EINSCHLÄGIGE DOKUMENTE | | KLASSIFIKATION DER ANMELDUNG (Int.Cl. 3) |
|---|---|---|---|
| | Kennzeichnung des Dokuments mit Angabe, soweit erforderlich, der maßgeblichen Teile | betrifft Anspruch | |
| | "NETIC AND CO-NETIC MAGNETIC SHIEL-DING MANUAL", 101-122, (herausge-geben von Magnetic Shield Division of, Perfection Mica Company) Chicago, U.S.A. nicht datiertes Dokument vor dem 27. Dezember 1978 veröffentlicht im e e m File System (electronic engineers master) Sec. 2500 Seiten 1-32 <br><br> * Bilder und Text, Seite 11 * <br><br> -- | 1,2 | H 01 F 15/04 <br> H 03 H  1/00 <br> H 05 K  9/00 <br> H 01 F 27/36 |
| | US - A - 1 927 065 (E. FRANZ) <br> * Ganzes Dokument * <br><br> -- | 1-4 | RECHERCHIERTE SACHGEBIETE (Int. Cl. 3) |
| | GB - A - 1 386 077 (CHEW SENG KOH) <br> * Ganzes Dokument * <br><br> -- | 1 | H 01 F 15/04 <br>         27/36 <br> H 03 H  1/00 <br> H 05 K  9/00 <br> H 01 F 27/02 <br>         27/26 |
| | DE - U - 1 718 658 (FELTEN & GUILLEAUME) <br> * Ganzes Dokument * <br><br> -- | 1 | |
| | US - A - 3 037 176 (D. CHAPMAN) <br> * Ganzes Dokument * <br><br> -- | 1 | KATEGORIE DER GENANNTEN DOKUMENTE <br><br> X: von besonderer Bedeutung <br> A: technologischer Hintergrund <br> O: nichtschriftliche Offenbarung <br> P: Zwischenliteratur |
| A | FR - A - 2 110 387 (SIEMENS) <br> * Ganzes Dokument * <br><br> -- | 1,3 | T: der Erfindung zugrunde liegende Theorien oder Grundsätze <br> E: kollidierende Anmeldung <br> D: in der Anmeldung angeführtes Dokument |
| A | GB - A - 1 043 795 (M.E.L. EQUIP-MENT COMPANY) | 1,3 | L: aus andern Gründen angeführtes Dokument <br> &: Mitglied der gleichen Patent- |

| Der vorliegende Recherchenbericht wurde für alle Patentansprüche erstellt | | familie, übereinstimmendes Dokument |
|---|---|---|
| Recherchenort <br> Den Haag | Abschlußdatum der Recherche <br> 10-04-1980 | Prüfer <br> DECONINCK |

EPA form 1503.1  06.78

0013364
Nummer der Anmeldung

Europäisches
Patentamt

EUROPÄISCHER RECHERCHENBERICHT

EP 79 10 5076

-2-

| EINSCHLÄGIGE DOKUMENTE | | | KLASSIFIKATION DER ANMELDUNG (Int.Cl. ⁴) |
|---|---|---|---|
| Kategorie | Kennzeichnung des Dokuments mit Angabe, soweit erforderlich, der maßgeblichen Teile | betrifft Anspruch | |
| | * Ganzes Dokument * -- | | |
| A | DE - A - 2 446 714 (SIEMENS) * Ganzes Dokument * -- | 1,3,4 | |
| A | GB - A - 813 901 (GRESHAM TRANS-FORMERS LIMITED) * Ganzes Dokument * ---- | 1,3 | RECHERCHIERTE SACHGEBIETE (Int. Cl. ³) - |

EPA Form 1503.2 06.78